# EUROPEAN PATENT APPLICATION

(11) **EP 1 400 987 A2**
(43) Date of publication of application: **24.03.2004**
(21) Application number: 03020066.1
(22) Date of filing: 04.09.2003
(51) Int. Cl.: H01B 1/16, H01L 31/04

(54) **Conductive paste, method for manufacturing solar battery, and solar battery**

(30) Priority: 19.09.2002 JP 2002273151
(71) Applicant: Murata Manufacturing Co., Ltd., Nagaokakyo-shi Kyoto-fu 617-8555 (JP)
(72) Inventor: Nagakubo, Hiroshi, Nagaokakyo-shi Kyoto-fu 617-8555 (JP); Adachi, Fumiya, Nagaokakyo-shi Kyoto-fu 617-8555 (JP)
(74) Representative: Laufhütte, Dieter, Dr.-Ing.

(57) **Abstract**

A conductive paste used for a rear electrode of a Si solar battery includes an Al powder, a glass frit, an organic vehicle and particles insoluble or slightly soluble in the organic vehicle. The particles are constituted of an organic compound or carbon or both. The conductive paste does not shrink much during firing and, consequently reduces the amount of Si wafer warping while maintaining the functions of a rear electrode for a Si solar battery.

## Description

### BACKGROUND OF THE INVENTION

### 1. Field of the Invention

The present invention relates to a conductive paste used for a rear electrode of a Si solar battery, a method for manufacturing a solar battery using the conductive paste, and a solar battery.

### 2. Description of the Related Art

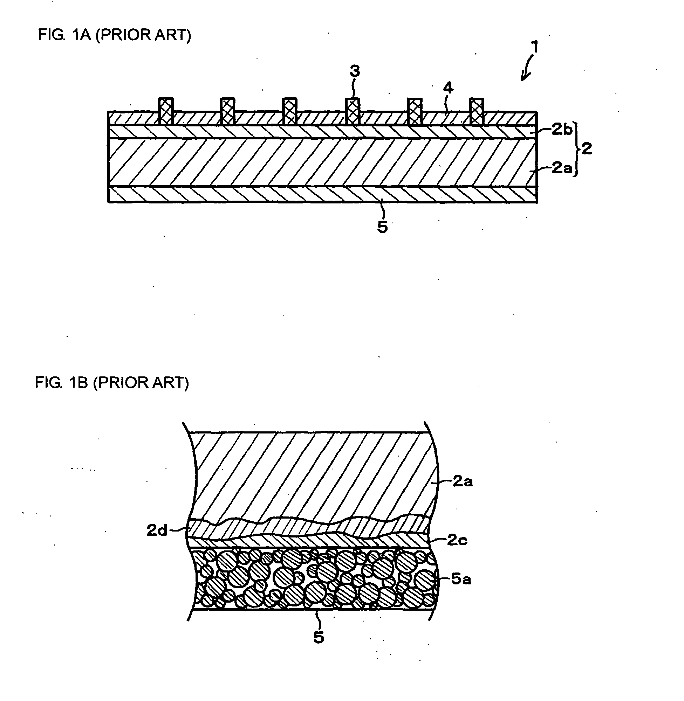

Fig. 1A shows the structure in a cross-sectional view of a known Si solar battery. The Si solar battery 1 includes a Si wafer 2 having a p-Si layer 2a and an n-Si layer 2b, light-receptive surface electrodes 3 and antireflection films 4 on the n-Si layer 2b, and a rear electrode 5 on the p-Si layer 2a.

In generally, an Al paste containing an Al powder and a glass frit dispersed in an organic vehicle has advantageously been used to make the rear electrode of Si solar batteries, from the viewpoint of workability of forming the electrode.

The rear electrode 5 is formed through the following process. A conductive paste containing an Al powder 5a and a glass frit dispersed in an organic vehicle is applied onto the entire surface of the p-Si layer 2a of the Si wafer 2 by, for example, screen printing, followed by drying. Then, the conductive paste is fired at a temperature more than or equal to 660°C, which is the melting point of the Al powder, in a near-infrared oven to remove organic components and sinter the Al powder 5a. Thus, the rear electrode 5 is formed to a thickness of about 40 to 100 µm.

In this firing process, the conductive paste reacts with the p-Si layer 2a to form an Al-Si alloy layer 2c on the p-Si layer side of the bonded interface, and Al ions diffuse into the p-Si layer 2a through the Al-Si alloy layer 2c to form a p+ electrolyte layer 2d, as shown in Fig. 1B. The Al-Si alloy layer 2c and the p+ electrolyte layer 2d ensure ohmic contact between the resulting rear electrode 5 and the p-Si layer 2a, and produce the effects of reflecting long-wavelength light, preventing recombination of electrons, and enhancing internal electrolysis and other effects to enhance the performance of the Si solar battery.

For conductive pastes for the rear electrodes of Si solar batteries, various effective techniques have been disclosed as to the fundamental material composition, the organic vehicle, the glass frit, and the Al powder, in, for example, Japanese Unexamined Patent Application Publication Nos. 10-247418, 2000-090733, and 2001-202822. These techniques contribute to ensuring ohmic contact of the rear electrode with the p-Si layer, to enhancing the effects of reflecting long-wavelength light, of preventing recombination of electrons, and of increasing internal electrolysis and other Si solar battery characteristics, and to improving electrode formability.

Also, Japanese Unexamined Patent Application Publication No. 2001-313402 discloses a technique for reducing the amount of Si wafer warping by replacing part of an Al powder in a conductive paste with Si particles so as to bring the thermal expansion coefficient of the electrode close to that of the Si wafer.

If the conductive pastes disclosed in the foregoing first three patent documents are formed into an electrode through the steps of applying them onto the entirety of one surface of a Si wafer (substrate), drying and firing, however, they cause the Si wafer to warp due to the shrinkage of the electrode during firing and the difference in thermal expansion coefficient between the Si wafer and the Al-Si alloy layer formed at the interface between the Si wafer and the electrode. The Si wafer warping is likely to bring about handling errors and fractures in the Si wafer during transfer, cassette housing, and other process steps after the formation of the rear electrode in the manufacture of Si solar batteries, thus reducing process yield. It has been considered to reduce the thickness of Si wafers and to increase the area thereof in order to increase solar battery productivity, and accordingly, reduction of the amount of Si wafer warping has become important increasingly.

In order to completely prevent the Si wafer from warping by changing the thermal expansion coefficient of the electrode to be substantially equal to that of the Si wafer as in the conductive paste disclosed in the foregoing fourth patent document, essentially the entire amount of the Al powder in a paste composition has to be replaced with Si particles. The reason is that in order to reduce the amount of Si wafer warping to a required level, a large amount of Si particles needs to be added. This, however, negatively affects characteristics of the resulting electrode. Therefore, the technique proposed by the document has achieved only limited success.

### SUMMARY OF THE INVENTION

Accordingly, an object of the present invention is to provide a conductive paste for rear electrodes of Si solar batteries that does not shrink much when firing so as to reduce the amount of Si wafer warping while maintaining the functions of the rear electrode. Another object of the present invention is to provide a solar battery which does not warp much, and method for manufacturing a solar battery that can achieve a high yield and productivity.

According to an aspect of the present invention, a conductive paste used for a rear electrode of a Si solar battery is provided. The conductive paste comprises an Al powder, a glass frit, an organic vehicle and particles insoluble or slightly soluble in the organic vehicle. The particles are constituted by at least one of an organic compound and carbon.

Preferably, the mean particle size of the particles is in the range of about 0.5 to 10 µm.

Preferably, the particle content is in the range of about 1 to 10 parts by weight relative to 100 parts by weight of the Al powder.

According to another aspect of the present invention, a method for manufacturing a solar battery including a Si wafer having a p-Si layer and an n-Si layer, a light-receptive surface electrode on the n-Si layer, and a rear electrode on the p-Si layer is provided. The method includes the step of forming the rear electrode by applying a conductive paste onto the p-Si layer of the Si wafer and firing the conductive paste. The conductive paste comprises an Al powder, a glass frit, an organic vehicle and particles insoluble or slightly soluble in the organic vehicle where the particles comprise at least one of an organic compound and carbon.

Preferably, the rear electrode has pores with a mean diameter in the range of about 0.5 to 10 µm, and more preferably, the pores occupy about 1 to 20 percent of the volume of the rear electrode.

According to still another aspect of the present invention, a solar battery is provided which includes a Si wafer having a p-Si layer and an n-Si layer, a light-receptive surface electrode on the n-Si layer and a rear electrode on the p-Si layer. The rear electrode has pores with a mean diameter in the range of about 0.5 to 10 µm, and the pores occupy about 1 to 20 percent of the volume of the rear electrode.

"Particles slightly soluble in the organic vehicle" herein refer to particles have a solubility of 50 percent by weight or less (0 to 50 percent by weight) in the organic vehicle.

As described above, the conductive paste used for a rear electrode of a Si solar battery comprises an Al powder, a glass frit, an organic vehicle, and organic or carbon particles insoluble or slightly soluble in the organic vehicle. Although these organic or carbon particles are present in a solid form in the paste, they are burned and disappear during firing. Consequently, many pores are formed in the resulting electrode. These pores reduce the shrinkage of the electrode by firing, consequently reducing the amount of Si wafer warping.

Accordingly, the amount of Si wafer warping can be reduced by using the conductive paste of the present invention for a rear electrode of a Si solar battery. Thus, cracks in the Si wafer are prevented to increase process yield. The conductive paste of the present invention contributes to practical application of a solar battery including a Si wafer with a small thickness and a large area.

### BRIEF DESCRIPTION OF THE DRAWINGS

Fig. 1A is a sectional view of a Si solar battery having a rear electrode formed of a conductive paste,
Fig. 1B is a sectional view of the interface between a p-Si layer and the rear electrode of the Si solar battery shown in Fig. 1A;
Fig. 2 is a sectional view of a Si wafer having a rear electrode formed of a conductive paste; and
Fig. 3A is an SEM photograph of the section of a rear electrode formed of a conductive paste according to the present invention, and
Fig. 3B is an SEM photograph of the section of a rear electrode formed of a conductive paste prepared in a comparative example.

### DESCRIPTION OF THE PREFERRED EMBODIMENTS

A conductive paste used for a rear electrode of a Si solar battery according to the present invention contains an Al powder, a glass frit, an organic vehicle and particles slightly soluble or insoluble in the organic vehicle. The particles are constituted of an organic compound or carbon or both.

The Al powder, the glass frit and the organic vehicle are not particularly limited, as long as they are generally used for Al pastes. Specifically, the Al powder may have various particle shapes, such as sphere, flat, and indefinite shapes, and its particle size is preferably in the range of about 1 to 10 µm. The glass frit may contain SiO₂-PbO, SiO₂-B₂O₃-PbO, or Bi₂O₃ -SiO₂ - B₂O₃. The organic vehicle is generally a cellulose or alkyd resin dissolved in an organic solvent, such as terpineol, Carbitol or Cellosolve, and may further contain additives, such as a plasticizer and a finishing agent, if necessary. The conductive paste generally contains about 60 to 80 percent by weight of Al powder, about 1 to 5 percent by weight of glass frit, and about 15 to 40 percent by the organic vehicle.

The slightly soluble or insoluble particles in the organic vehicle are constituted of an organic compound or carbon or both. Since these particles are present in solid form in the paste due to their insolubility in the organic vehicle, the paste results in a film in which the particles are dispersed when applied onto a Si wafer (substrate) by, for example, screen printing and being dried. Then, the dried film is fired so that the particles dispersed in the film are burned and disappear. Thus, the resulting electrode has many pores. These pores reduce the shrinkage of the electrode attributed to firing, consequently reducing the amount of Si wafer warping.

Any organic or carbon particles which are insoluble or slightly soluble in the organic vehicle and capable of being burned so as to disappear during firing can produce this effect. Particularly preferred particles are constituted of a synthetic resin made of a thermoplastic resin such as polyethylene or polypropylene, a thermosetting resin such as an epoxy resin or a polyurethane resin, in view of insolubility in the organic vehicle and combustibility.

The particles may have various particle shapes, such as sphere, flat, and indefinite shapes, and its mean particle size is preferably in the range of about 0.5 to 10 µm. Particles having a mean particle size of less than about 0.5 µm are liable to aggregate and absorb a large amount of oil due to their large specific surface area, consequently making it difficult to uniformly disperse in the paste in some cases. Also, the viscosity of the paste may be seriously increased. In contrast, particles having a mean particle size of more than about 10 µm clog a screen printing apparatus to hinder the formation of a uniform electrode, in some cases. In addition, these particles are locally and violently burned to produce a gas, and the gas may locally break the electrode to increase appearance failure and to negatively affect electrode performance.

Preferably, the particle content in the conductive paste is in the range of about 1 to 10 parts by weight relative to 100 parts by weight of Al powder. A particle content lower than about 1 part by weight to 100 parts by weight of Al powder leads to a reduced proportion of pores to the electrode, and, thus, do not reduce the electrode shrinkage attributed to firing effectively. Consequently, the amount of Si wafer warping may not be reduced effectively. In contrast, a particle content higher than about 10 parts by weight to 100 parts by weight of Al powder leads to an increased ratio of the pores to the electrode, and thus, negatively affects the mechanical strength of the electrode. Also, a gas produced by firing may break the electrode to cause appearance failure, such as occurrence of voids or cracks and, further, to seriously degrade electrode performance.

A Si solar battery 1 of the present invention includes a Si wafer 2 having a p-Si layer 2a and an n-Si layer 2b, light-receptive surface electrodes 3 on the n-Si layer 2b and a rear electrode 5 on the p-Si layer 2a, as shown in the sectional view of Fig. 1A. Preferably, antireflection films 4 are provided on the n-Si layer 2b, that is, on the light-receptive surface side, for preventing light reflection, as shown in Fig. 1A.

The rear electrode 5 has pores with a mean diameter of about 0.5 to 10 µm, occupying about 1 to 20 percent of the volume of the rear electrode. Preferably, these pores occupy about 3 to 15 percent of the rear electrode volume and have a mean diameter of about 1 to 8 µm. Since the electrode has a predetermined amount of pores with a predetermined size, the pores in the rear electrode reduce the shrinkage of the electrode attributed to firing. Consequently, the amount of Si wafer warping in the resulting Si solar battery is reduced. The thickness of the rear electrode may be in the range of about 20 to 100 µm.

The rear electrode 5 may be formed, for example, through the following process. A conductive paste containing an Al powder and an glass frit, an organic vehicle and particles of an organic compound or carbon or both, insoluble or slightly soluble in the organic vehicle, is applied onto the entire surface of the p-Si layer 2a of the Si wafer 2 by screen printing or the like, followed by drying. Then, the conductive paste is fired at a temperature more than or equal to 660°C, which is the melting point of the Al powder, in a near-infrared oven to remove organic components and sinter the Al powder 5a. Thus, the rear electrode 5 is completed.

In this firing process, the conductive paste reacts with the p-Si layer 2a to form an Al-Si alloy layer 2c on the p-Si layer side at the bonded interface, and Al ions diffuse into the p-Si layer 2a through the Al-Si alloy layer 2c to form a p+ electrolyte layer 2d. The Al-Si alloy layer 2c and the p+ electrolyte layer 2d ensure ohmic contact between the resulting rear electrode 5 and the p-Si layer 2a, and produce the effects of reflecting long-wavelength light, preventing recombination of electrons, and enhancing internal electrolysis and other effects to enhance Si solar battery performance. The amount and size of the pores can be adjusted by varying the mean particle size or content of the particles insoluble or slightly soluble in the organic vehicle.

### Examples

### Example 1

An Al powder with a mean particle size of 3 µm, a SiO₂-PbO-B₂O₃ glass frit with a mean particle size of 1 µm, and an organic vehicle were prepared. The organic vehicle contained an ethyl cellulose resin and an alkyd resin that were dissolved in α-terpineol. The organic compounds or carbon particles shown in Table 1 are prepared as the particles insoluble or slightly soluble in the organic vehicle. The mean particle sizes of these particles were measured with a laser diffraction-scattering size distribution measuring system, using a mixed solvent of ethanol and isopropyl alcohol as a dispersion medium.

Then, the Al powder, the glass frit and the organic vehicle were weighed out so as to be 70 percent by weight of Al powder, 3 percent by weight of glass frit and 27 percent by weight of the organic vehicle. Relative to 100 parts by weight of the Al powder, 5 parts by weight of particles shown in Table 1 were added. The mixture was kneaded with a three-roll mill and thus, samples 1 to 4 of the conductive paste were obtained. The carbon particles of Sample 3 shown in Table 1 were spherical carbon beads commonly used as a material for imparting conductivity.

For a comparative example, the Al powder, the glass frit and the organic vehicle were weighed out so as to be 70 percent by weight of Al powder, 3 percent by weight of glass frit and 27 percent by weight of the organic vehicle. These materials were kneaded with a three-roll mill. Thus, Sample 5, a conductive paste for the comparative example, was obtained.

**Table 1**

| SAMPLE | PARTICLE CONSTITUENT | MEANS PARTICLE SIZE (µm) |
|---|---|---|
| 1 | POLYETHYLENE | 5 |
| 2 | ACRYLIC RESIN | 5 |
| 3 | CARBON | 5 |
| 4 | TEREPHTHALIC ACID | 5 |

A Si wafer for a solar battery were prepared which contains a p-n junction and has a length of 40 mm, a width of 20 mm and a thickness of 350 µm. Then, each of Samples of 1 to 5 was applied onto substantially the entire surface of the p-Si layer of the Si wafer and dried at 150°C. Each sample was fired at temperatures up to 700°C in a near-infrared oven to form a rear electrode having a thickness of 30 µm. Thus tes t pieces of the rear electrode were prepared.

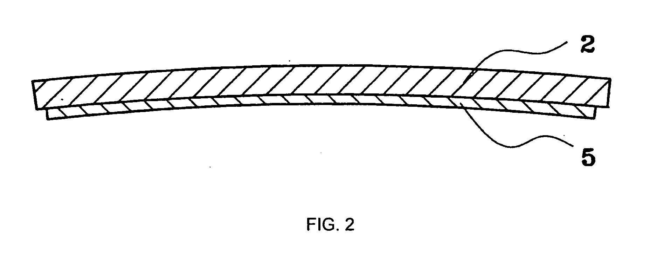

The amount of Si wafer warping in each test piece, which is a Si wafer having a rear electrode, was measured. The state of the rear electrode was observed. The results were shown in Table 2. Si wafer warping was measured with a contact-type surface roughness meter as to the curve of the upper surface (Si wafer side) of the test piece whose rear electrode faces downward, as shown in Fig. 2. The amount of Si wafer warping was defined by the height to the highest point being substantially the center in the longitudinal direction of the test piece from the lowest point on a line connecting both ends of the region of 35 mm in length around that center of the test piece.

**Table 2**

| SAMPLE | AMOUNT OF WARPING (µm) | STATE OF ELECTRODE SURFACE |
|---|---|---|
| 1 | 30 | NO VOID OR CRACK |
| 2 | 25 | NO VOID OR CRACK |
| 3 | 35 | NO VOID OR CRACK |
| 4 | 30 | NO VOID OR CRACK |
| *5 | 60 | NO VOID OR CRACK |

Table 2 shows that, in the rear electrodes formed of Samples 1 to 4, which contain particles insoluble or slightly soluble in the organic vehicle in an amount as small as 5 parts by weight relative to 100 parts by weight of Al powder, the amount of Si wafer warping was extremely reduced to less than or equal to about half that of the test piece of Sample 5 in the comparative example. Although there was no remarkable difference in type of particles, the test piece using an acrylic resin showed a less warp than others. The states of the electrode surfaces after firing were good without voids, cracks or other failures resulting from a gas produced by firing.

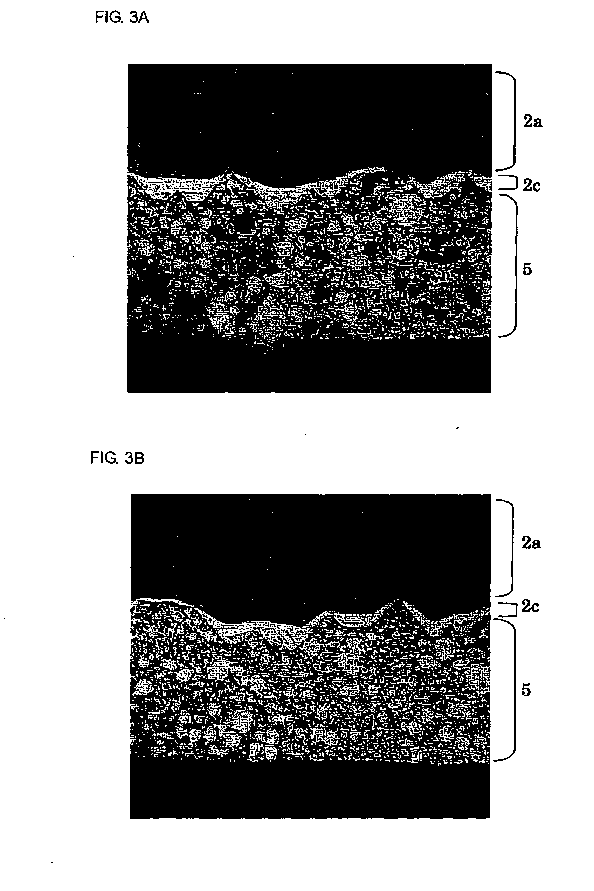

Figs. 3A and 3B are SEM photographs of the sections of the rear electrodes formed of Sample 2 according to the present invention and Sample 5 according to the comparative example, respectively. Figs. 3A and 3B show that Sample 2 forms many pores (black areas in the figure) in the rear electrode because of the presence of the organic particles. Also, the state of the resulting Al-Si alloy layer 2c, which is an essential part to function as a rear electrode of solar batteries, compares advantageously with that of Sample 5, even if many voids are formed in the electrode, as in Sample 2. Therefore, the conductive paste of the present invention can function as the rear electrode of Si solar batteries, as with the known conductive paste.

### Example 2

The same Al powder, glass frit and organic vehicle as in Example 1 were prepared. Acrylic resins having respective particle sizes of 0.3, 0.5, 1.5, 5.0 and 10 µm were prepared as the particles insoluble or slightly soluble in the organic vehicle.

Then, the Al powder, the glass frit and the organic vehicle were weighed out so as to be 70 percent by weight of Al powder, 3 percent by weight of glass frit and 27 percent by weight of the organic vehicle. Relative to 100 parts by weight of the Al powder, 5 parts by weight of acrylic resin particles having a varied particle size were added. The mixture was kneaded and, thus, Samples 6 to 10 of the conductive paste were obtained. Sample 6 exhibited a viscosity higher than that of the other conductive pastes.

Then, test pieces, each having a rear electrode on a Si wafer were prepared in the same manner as in Example 1. Then, Si wafer warping was measured and the state of the rear electrode was observed, in the same manner as in Example 1. The results were shown in Table 3. Table 3 includes the results with Sample 5, the comparative example, which did not contain particles insoluble or slightly soluble in the organic vehicle.

**Table 3**

| SAMPLE | MEAN PARTICLE SIZE (µm) | AMOUNT OF WARP (µm) | STATE OF ELECTRODE SURFACE |
|---|---|---|---|
| 6 | 0.3 | 43 | NO VOID OR CRACK |
| 7 | 0.5 | 35 | NO VOID OR CRACK |
| 8 | 1.5 | 30 | NO VOID OR CRACK |
| 9 | 5.0 | 25 | NO VOID OR CRACK |
| 10 | 10 | 30 | NO VOID OR CRACK |
| *5 | -- | 60 | NO VOID OR CRACK |

Table 3 shows that a mean particle size in the range of about 0.5 to 10 µm, as in Samples 7 to 10, is particularly preferably for the particles insoluble or slightly soluble in the organic vehicle.

### Example 3

The same A1 powder, glass frit and organic vehicle as in Example 1 were prepared. An acrylic resin having a mean particle size of 5.0 µm was prepared as the particles insoluble or slightly soluble in the organic vehicle.

Then, the A1 powder, the glass frit and the organic vehicle were weighed out so as to be 70 percent by weight of A1 powder, 3 percent by weight of glass frit and 27 percent by weight of the organic vehicle. Relative to 100 parts by weight of the A1 powder, 0.5, 1.0, 2.5, 5.0, 7.5 and 10 parts by weight of the acrylic resins were each added and kneaded. Thus, Samples 11 to 16 of the conductive paste were obtained.

Then, test pieces having a rear electrode on a Si wafer were prepared in the same manner as in Example 1. Then, Si wafer warping was measured and the state of the rear electrode was observed, in the same manner as in Example 1. The results were shown in Table 4. Table 4 includes the results using Sample 5, the comparative example, which did not contain particles insoluble or slightly soluble in the organic vehicle.

**Table 4**

| SAMPLE | CONTENT (PART BY WEIGHT) | AMOUNT OF WARP (µm) | STATE OF ELECTRODE SURFACE |
|---|---|---|---|
| 11 | 0.5 | 45 | NO VOID OR CRACK |
| 12 | 1.0 | 40 | NO VOID OR CRACK |
| 13 | 2.5 | 30 | NO VOID OR CRACK |
| 14 | 5.0 | 25 | NO VOID OR CRACK |
| 15 | 7.5 | 22 | NO VOID OR CRACK |
| 16 | 10 | 30 | NO VOID OR CRACK |
| *5 | -- | 60 | NO VOID OR CRACK |

Table 4 shows that a content of the particles insoluble or slightly soluble in the organic vehicle in the range of about 1 to 10 parts by weight to 100 parts by weight of Al powder, as in Samples 12 to 16, is particularly preferable.

## Claims

1. A conductive paste used for a rear electrode of a Si solar battery, the conductive paste comprising:
an Al powder;
a glass frit;
an organic vehicle; and
particles of at least one of an organic compound and carbon which are insoluble or slightly soluble in the organic vehicle.

2. A conductive paste according to Claim 1, wherein the mean particle size of the particles is in the range of about 0.5 to 10 µm.

3. A conductive paste according to Claim 2, wherein the particle content is in the range of about 1 to 10 parts by weight relative to 100 parts by weight of the Al powder.

4. A conductive paste according to Claim 3, wherein the Al powder is about 60-80 wt% of the paste and has a particle size of about 1-10 µm, the glass frit is about 1-5 wt% of the paste, and the organic vehicle is about 15-40 wt% of the paste.

5. A conductive paste according to Claim 4, wherein the organic compound is selected from the group consisting of polyolefin resin, epoxy resin, polyurethane resin, acrylic resin and terephthalic acid.

6. A conductive paste according to Claim 1, wherein the particle content is in the range of about 1 to 10 parts by weight relative to 100 parts by weight of the Al powder.

7. A conductive paste according to Claim 1, wherein the Al powder is about 60-80 wt% of the paste and has a particle size of about 1-10 µm, the glass frit is about 1-5 wt% of the paste, and the organic vehicle is about 15-40 wt% of the paste.

8. A conductive paste according to Claim 1, wherein the organic compound is selected from the group consisting of polyolefin resin, epoxy resin, polyurethane resin, acrylic resin and terephthalic acid.

9. A method for manufacturing a solar battery including a Si wafer having a p-Si layer and an n-Si layer, a light-receptive surface electrode on the n-Si layer, and a rear electrode on the p-Si layer, the method comprising :
forming the rear electrode by applying a conductive paste onto the p-Si layer of the Si wafer and firing the conductive paste, wherein the conductive paste comprises an Al powder, a glass frit, an organic vehicle and particles of at least one of an organic compound and carbon which are insoluble or slightly soluble in the organic vehicle.

10. A method for manufacturing a solar battery according to Claim 9, wherein the particles have a mean diameter in the range of about 0.5 to 10 µm.

11. A method for manufacturing a solar battery according to Claim 10, wherein the particles constitute about 1 to 10 parts per 100 parts of aluminum powder.

12. A method for manufacturing a solar battery according to Claim 11, wherein the Al powder is about 60-80 wt% of the paste and has a particle size of about 1-10 µm, the glass frit is about 1-5 wt% of the paste, and the organic vehicle is about 15-40 wt% of the paste.

13. A method for manufacturing a solar battery according to Claim 12, wherein the organic compound is selected from the group consisting of polyolefin resin, epoxy resin, polyurethane resin, acrylic resin and terephthalic acid.

14. A method for manufacturing a solar battery according to Claim 9, wherein the Al powder is about 60-80 wt% of the paste and has a particle size of about 1-10 µm, the glass frit is about 1-5 wt% of the paste, and the organic vehicle is about 15-40 wt% of the paste.

15. A method for manufacturing a solar battery according to Claim 9, wherein the organic compound is selected from the group consisting of polyolefin resin, epoxy resin, polyurethane resin, acrylic resin and terephthalic acid.

16. A solar battery comprising:
a Si wafer having a p-Si layer and an n-Si layer;
a light-receptive surface electrode on the n-Si layer, and
a rear electrode on the p-Si layer,
wherein the rear electrode contains pores with a mean diameter in the range of about 0.5 to 10 µm, occupying about 1 to 20 percent of the volume of the rear electrode.

17. A solar battery according to Claim 16, wherein the rear electrode contains pores with a mean diameter in the range of about 1 to 8 µm, occupying about 3 to 15 percent of the volume of the rear electrode.

18. A solar battery according to Claim 17, wherein the rear electrode has a thickness of about 20 to 100 µm.

19. A solar battery according to Claim 16, wherein the rear electrode has a thickness of about 20 to 100 µm.
